# FASCICULE DE BREVET EUROPEEN

(11) **EP 4 481 487 B1**
(45) Date de publication et mention de la délivrance du brevet: **15.10.2025**
(21) Numéro de dépôt: 24181622.2
(22) Date de dépôt: 12.06.2024
(51) Int. Cl.: G02F 1/313, G02B 6/35, H01Q 15/00

(54) **COMMUTATEUR À BASE DE MATÉRIAU À CHANGEMENT DE PHASE**
SCHALTER AUF BASIS VON PHASENWECHSELMATERIAL
PHASE CHANGE MATERIAL BASED SWITCH

(30) Priorité: 20.06.2023 FR 2306345
(43) Date de publication de la demande: 25.12.2024
(73) Titulaire: Commissariat à l'Energie Atomique et aux Energies Alternatives, 75015 Paris (FR)
(72) Inventeur: CHARLET, Ismaël, 38054 GRENOBLE CEDEX 09 (FR)
(74) Mandataire: Cabinet Beaumont

(56) Documents cités:
- WO-A1-2021/255451
- US-A1- 2023 129 840
- US-B2- 11 231 635
- LIANG WEILI ET AL: "Switchable waveguide mode converter based on phase change material", 20230412, vol. 12565, 12 April 2023 (2023-04-12), pages 125651F - 125651F, XP060177311, ISSN: 0277-786X, ISBN: 978-1-5106-6247-6, DOI: 10.1117/12.2662230

## Description

### Domaine technique

La présente description concerne de façon générale les dispositifs électroniques. La présente description concerne plus particulièrement les commutateurs à base d'un matériau à changement de phase, capable d'alterner entre une phase cristalline, électriquement conductrice, et une phase amorphe, électriquement isolante.

### Technique antérieure

Diverses applications tirent profit de commutateurs, ou interrupteurs, à base d'un matériau à changement de phase pour permettre ou empêcher une circulation d'un courant électrique dans un circuit, par exemple dans le document US 11 231 635**.** De tels commutateurs peuvent notamment être mis en œuvre dans des applications de communication radiofréquence, par exemple pour commuter une antenne entre des modes d'émission et de réception, activer un filtre correspondant à une bande de fréquences, etc.

Les commutateurs à base d'un matériau à changement de phase existants souffrent toutefois de divers inconvénients. Résumé de l'invention

Il existe un besoin d'améliorer les commutateurs à base d'un matériau à changement de phase existants.

Pour cela, un mode de réalisation prévoit un commutateur à base d'un matériau à changement de phase comprenant :
- une région en ledit matériau à changement de phase reliant des première et deuxième électrodes de conduction du commutateur ; et
- un coupleur optique d'un signal laser d'activation du commutateur, situé en vis-à-vis d'une face de la région en ledit matériau à changement de phase.

Selon un mode de réalisation, le coupleur optique comprend des premier et deuxième guides d'ondes superposés en vis-à-vis de ladite face, le deuxième guide d'ondes étant interposé entre le premier guide d'ondes et la région en ledit matériau à changement de phase.

Selon un mode de réalisation, les premier et deuxième guides d'ondes comprennent chacun une région centrale en un premier matériau entourée par une région périphérique en un deuxième matériau d'indice optique inférieur à celui du premier matériau.

Selon un mode de réalisation, les régions centrales des premier et deuxième guides d'ondes sont superposées, en regard l'une de l'autre et présentent un même tracé à l'aplomb de la région en ledit matériau à changement de phase.

Selon un mode de réalisation, les régions centrales des premier et deuxième guides d'ondes ne présentent pas un même tracé hors de l'aplomb de la région en ledit matériau à changement de phase.

Selon un mode de réalisation, la région centrale du premier guide d'ondes présente une géométrie et des dimensions sensiblement identiques à celles de la région centrale du deuxième guide d'ondes.

Selon un mode de réalisation, le coupleur optique est un coupleur adiabatique.

Selon un mode de réalisation, les premier et deuxième guide d'ondes comportent respectivement des surfaces de sortie et d'entrée présentant chacune, en vue de dessus, une forme fuselée.

Selon un mode de réalisation, le signal laser est confiné et guidé majoritairement par le premier guide d'ondes, en entrée du coupleur optique, et majoritairement par le deuxième guide d'ondes, en sortie du coupleur optique.

Selon un mode de réalisation, les première et deuxième électrodes de conduction font partie d'un élément d'antenne d'une cellule de réseau transmetteur ou de réseau réflecteur.

Un mode de réalisation prévoit une cellule de réseau transmetteur ou de réseau réflecteur comprenant au moins un commutateur tel que décrit.

Un mode de réalisation prévoit un réseau transmetteur ou un réseau réflecteur comprenant :
- une pluralité de cellules telles que décrites ;
- une ou plusieurs sources laser ; et
- un circuit de commande de la ou des sources laser.

Selon un mode de réalisation, chaque source laser fait partie d'une même puce que chaque commutateur auquel elle est associée.

Un mode de réalisation prévoit une antenne comprenant un réseau transmetteur ou un réseau réflecteur tel que décrit et au moins une source configurée pour irradier une face du réseau.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1A et la figure 1B sont des vues schématiques et partielles, respectivement de dessus et en coupe selon le plan BB de la figure 1A, illustrant un exemple de commutateur à base d'un matériau à changement de phase ;
la figure 2A, la figure 2B et la figure 2C sont des vues schématiques et partielles, respectivement de dessus, en coupe selon le plan BB de la figure 2A et en coupe selon le plan CC de la figure 2A, illustrant un exemple de commutateur à base d'un matériau à changement de phase selon un mode de réalisation ;
la figure 3 est une vue de côté, schématique et partielle, d'un exemple d'antenne à réseau transmetteur du type auquel s'appliquent, à titre d'exemple, des modes de réalisation décrits ;
la figure 4 est une vue isométrique, schématique et partielle d'une cellule élémentaire du réseau transmetteur de l'antenne de la figure 3 selon un mode de réalisation ; et
la figure 5 est une vue de dessus, schématique et partielle, illustrant un exemple de commutateur à base d'un matériau à changement de phase selon un mode de réalisation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les circuits de commande des commutateurs à base d'un matériau à changement de phase et les applications dans lesquelles peuvent être prévus de tels commutateurs n'ont pas été détaillés, les modes de réalisation et variantes décrits étant compatibles avec les circuits de commande des commutateurs à base d'un matériau à changement de phase usuels et avec les applications usuelles mettant en œuvre des commutateurs à base d'un matériau à changement de phase.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais « coupled ») entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes « avant », « arrière », « haut », « bas », « gauche », « droite », etc., ou relative, tels que les termes « dessus », « dessous », « supérieur », « inférieur », etc., ou à des qualificatifs d'orientation, tels que les termes « horizontal », « vertical », etc., il est fait référence, sauf précision contraire, à l'orientation des figures.

Sauf précision contraire, les expressions « environ », « approximativement », « sensiblement », et « de l'ordre de » signifient à 10 % près, de préférence à 5 % près.

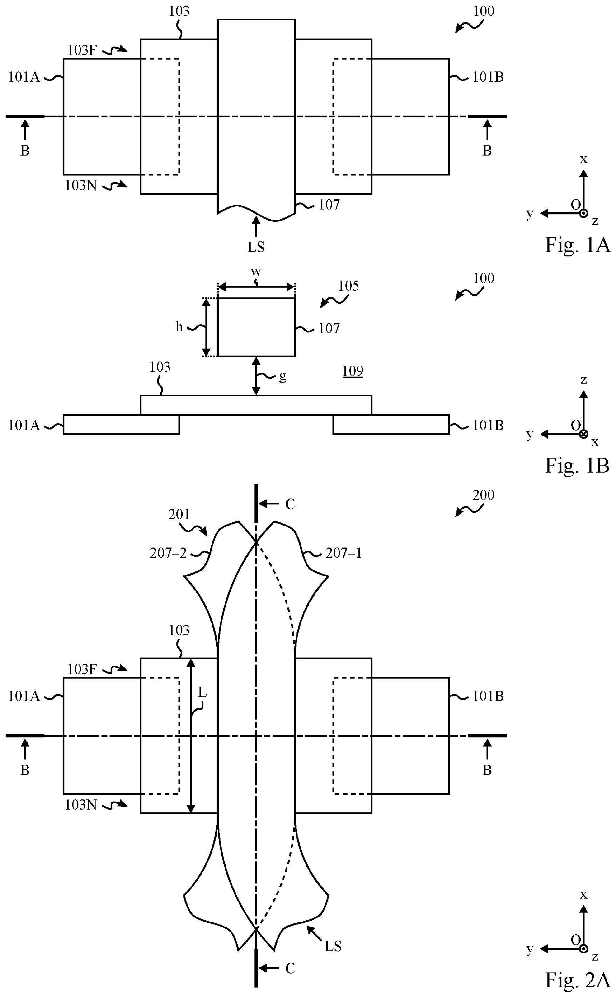

La figure 1A et la figure 1B sont des vues schématiques et partielles, respectivement de dessus et en coupe selon le plan BB de la figure 1A, illustrant un exemple de commutateur 100 à base d'un matériau à changement de phase. Dans l'exemple illustré, le plan BB de la figure 1A est un plan vertical parallèle à une direction de conduction du commutateur 100.

En figures 1A et 1B, la direction de conduction du commutateur 100 est parallèle à un axe horizontal Oy, et le plan BB est parallèle à un plan vertical Oyz orthogonal à un axe Ox.

Dans l'exemple représenté, le commutateur 100 comprend des électrodes de conduction 101A et 101B. Les électrodes de conduction 101A et 101B du commutateur 100 sont par exemple destinées à être connectées à un circuit de communication radiofréquence, non détaillé sur les figures. Les électrodes de conduction 101A et 101B sont en un matériau électriquement conducteur, par exemple un métal, par exemple le cuivre ou l'aluminium, ou en un alliage métallique. Par ailleurs, les électrodes de conduction 101A et 101B peuvent présenter une structure monocouche ou multicouche.

Bien que cela n'ait pas été détaillé en figures 1A et 1B afin de ne pas surcharger le dessin, les électrodes de conduction 101A et 101B du commutateur 100 sont par exemple situées sur et en contact avec une face supérieure d'une couche électriquement isolante, par exemple en dioxyde de silicium (SiO₂), revêtant un substrat. À titre d'exemple, le substrat est dans ce cas une plaquette ou un morceau de plaquette en un matériau semiconducteur, par exemple le silicium.

Dans l'exemple illustré, le commutateur 100 comprend en outre une région 103 en un matériau à changement de phase reliant les électrodes de conduction 101A et 101B. Bien que cela n'ait pas été détaillé sur les figures, la région 103 en matériau à changement de phase revêt par exemple une face supérieure d'une autre couche électriquement isolante, par exemple en dioxyde de silicium, s'étendant latéralement entre les électrodes 101A et 101B, la couche électriquement isolante affleurant par exemple les faces supérieures des électrodes 101A et 101B. Dans l'exemple représenté, la région 103 en matériau à changement de phase se prolonge sur et en contact avec une partie de la face supérieure de chaque électrode de conduction 101A, 101B. À titre d'exemple, la région 103 en matériau à changement de phase présente une épaisseur de l'ordre de 100 nm.

À titre d'exemple, la région 103 du commutateur 100 est en un matériau dit « chalcogénure », c'est-à-dire un matériau ou un alliage comprenant au moins un élément chalcogène, par exemple un matériau de la famille du tellurure de germanium (GeTe), du tellurure d'antimoine (SbTe) ou du germanium-antimoine-tellure (GeSbTe, communément désigné par l'acronyme « GST »). À titre de variante, la région 103 est en dioxyde de vanadium (VO₂).

De manière générale, les matériaux à changement de phase sont des matériaux capables d'alterner, sous l'effet d'une variation de température, entre une phase cristalline et une phase amorphe, la phase amorphe présentant une résistance électrique supérieure à celle de la phase cristalline. Dans le cas du commutateur 100, on tire profit de ce phénomène pour obtenir un état bloqué, empêchant la circulation d'un courant entre les électrodes de conduction 101A et 101B, lorsque le matériau de la région 103 située entre les électrodes de conduction est dans la phase amorphe, et un état passant, permettant la circulation du courant entre les électrodes de conduction 101A et 101B, lorsque le matériau de la région 103 est dans la phase cristalline.

Dans l'exemple représenté, le commutateur 100 comprend en outre un guide d'ondes 105 situé en vis-à-vis de la région 103 en matériau à changement de phase et s'étendant latéralement le long d'une direction principale sensiblement orthogonale à la direction de conduction du commutateur 100. En figures 1A et 1B, le guide d'ondes 105 du commutateur 100 s'étend parallèlement à l'axe Ox. Le guide d'ondes 105 comporte par exemple une première extrémité située en vis-à-vis d'une face supérieure de la région 103 en matériau à changement de phase et une deuxième extrémité, opposée à la première extrémité, destinée à être illuminée par une source laser LS. À titre d'exemple, le rayonnement émis par la source laser LS présente une polarisation transverse magnétique (TM) ou une polarisation transverse électrique (TE).

Dans l'exemple illustré, le guide d'ondes 105 comprend une région centrale 107, ou âme, entourée d'une région périphérique 109 électriquement isolante. Dans l'exemple illustré, la région centrale 107 du guide d'ondes 105 s'étend parallèlement à l'axe Ox. La région centrale 107 et la région périphérique 109 du guide d'ondes 105 sont en des matériaux choisis de sorte à obtenir un contraste d'indices optiques permettant de confiner et guider un mode optique d'intérêt émis par la source laser LS. Le matériau de la région centrale 107 du guide d'ondes 105 présente par exemple un indice optique supérieur à celui de la région périphérique 109. À titre d'exemple, la région centrale 107 du guide d'ondes 105 est en nitrure de silicium et la région périphérique 109 est en dioxyde de silicium.

Le plan BB de la figure 1A est sensiblement orthogonal à une direction de propagation du rayonnement laser dans le guide d'ondes 105. La direction de propagation du rayonnement laser dans le guide d'ondes 105 est, dans l'exemple illustré, parallèle à l'axe Ox. Dans l'exemple représenté, la région périphérique 109 du guide d'ondes 105 revêt les faces de la région centrale 107 parallèles à la direction de propagation du rayonnement laser (les faces latérales, inférieure et supérieure de la région centrale 107 du guide d'ondes 105 parallèles à l'axe Ox, en figures 1A et 1B). Dans cet exemple, une partie de la région périphérique 109 du guide d'ondes 105 s'étend verticalement, le long de l'axe vertical Oz orthogonal aux axes horizontaux Ox et Oy, depuis une face de la région centrale 107 située en regard de la région 103 en matériau à changement de phase (la face inférieure de la région centrale 107 du guide d'ondes 105, dans l'orientation de la figure 1B) jusqu'à une face de la région 103 en matériau à changement de phase opposée aux électrodes de conduction 101A et 101B (la face supérieure de la région 103 en matériau à changement de phase, dans l'orientation de la figure 1B).

Dans l'exemple représenté, la région centrale 107 présente, en vue en coupe selon le plan BB orthogonal à la direction de propagation du rayonnement laser dans le guide d'ondes 105, une section de forme sensiblement rectangulaire. À titre d'exemple, la région centrale 107 présente, en vue en coupe selon le plan BB, une largeur w (le long de l'axe Ox) égale à environ 300 nm et une hauteur h (le long de l'axe Oz) égale à environ 350 nm. Par ailleurs, la région centrale 107 du guide d'ondes 105 est séparée de la région 103 en matériau à changement de phase par une distance g. Dans cet exemple, la distance g équivaut à une épaisseur de la partie de la région périphérique 109 interposée entre la région centrale 107 du guide d'ondes 105 et la région 103 en matériau à changement de phase. À titre d'exemple, la distance g est égale à environ 300 nm.

Le guide d'ondes 105 est par exemple de type monomode, c'est-à-dire qu'il est adapté à confiner et guider un seul mode optique pour chaque type de polarisation. Le guide d'ondes 105 est par exemple plus précisément adapté à confiner et guider un seul mode optique choisi parmi un mode transverse électrique d'ordre zéro (TE0), parallèle à l'axe Oy, et un mode transverse magnétique d'ordre zéro (TM0), parallèle à l'axe Oz. Du fait que les modes TE0 et TM0 sont orthogonaux, ils ne peuvent pas se coupler mutuellement dans le guide d'ondes 105. Le choix du mode confiné et guidé par le guide d'ondes 105, entre le mode TE0 et le mode TM0, est déterminé par la polarisation de la source laser LS. Ainsi, dans un cas où la source laser LS émet un rayonnement présentant une polarisation transverse magnétique TM, le guide d'ondes 105 est adapté à confiner et guider le mode transverse magnétique d'ordre zéro TM0 uniquement.

Du côté de son extrémité destinée à être illuminée par la source laser LS, le guide d'ondes 105 comprend par exemple un élément de couplage d'entrée, aussi appelé surface d'entrée du guide d'ondes 105. Du côté de son extrémité située en vis-à-vis de la région 103 en matériau à changement de phase, le guide d'ondes 105 peut en outre comprendre un élément de couplage de sortie, aussi appelé surface de sortie du guide d'ondes 105. L'élément de couplage d'entrée peut présenter une structure, par exemple un réseau de diffraction présentant une structure de Bragg ou toute autre structure de couplage, permettant de capter le rayonnement émis par la source laser LS et de propager ce rayonnement jusqu'à la surface de sortie.

Par ailleurs, la surface de sortie du guide d'ondes 105 peut présenter une structure permettant de réémettre le rayonnement propagé depuis la surface d'entrée vers la région 103 en matériau à changement de phase. Bien que cela n'ait pas été détaillé en figures 1A et 1B, la surface de sortie du guide d'ondes 105 peut présenter une structure identique ou analogue à celle de sa surface d'entrée.

De manière générale, les surfaces d'entrée et de sortie du guide d'ondes 105 permettent respectivement, dans l'exemple représenté, de recevoir et de transmettre un rayonnement selon une direction orthogonale à la direction de propagation du rayonnement à l'intérieur du guide d'ondes 105, par exemple une direction parallèle à l'axe Oz. À titre de variante, au moins une surface, parmi les surfaces d'entrée et de sortie du guide d'ondes 105, peut présenter une structure permettant respectivement de recevoir ou de transmettre un rayonnement selon une direction parallèle à la direction de propagation du rayonnement à l'intérieur du guide d'ondes 105 (parallèle à l'axe Ox, dans cet exemple).

Pour faire basculer le commutateur 100 de l'état bloqué à l'état passant, on chauffe par exemple la région 103, à l'aide de la source laser LS, par l'intermédiaire du guide d'ondes 105, à une température T1 et pendant une durée d1. La température T1 et la durée d1 sont choisies de sorte à provoquer un changement de phase du matériau de la région 103 depuis la phase amorphe vers la phase cristalline. À titre d'exemple, la température T1 est supérieure à une température de cristallisation et inférieure à une température de fusion du matériau à changement de phase et la durée d1 est comprise entre 10 et 100 ns.

À l'inverse, pour faire basculer le commutateur 100 de l'état passant à l'état bloqué, on chauffe par exemple la région 103, à l'aide de la source laser LS, par l'intermédiaire du guide d'ondes 105, à une température T2, supérieure à la température T1, et pendant une durée d2, inférieure à la durée d1. La température T2 et la durée d2 sont choisies de sorte à provoquer un changement de phase du matériau de la région 103 depuis la phase cristalline vers la phase amorphe. À titre d'exemple, la température T2 est supérieure à la température de fusion du matériau à changement de phase et la durée d2 est de l'ordre de 10 ns.

À titre d'exemple, dans un cas où la source laser LS est à base de fluorure de krypton, un rayonnement présentant une longueur d'onde égale à environ 248 nm est émis par la source laser LS, par exemple sous forme d'impulsions, pour provoquer des transitions du matériau de la région 103 entre les phases amorphe et cristalline. Une impulsion présentant une fluence de l'ordre de 85 mJ.cm⁻² est par exemple utilisée pour obtenir une transition du matériau de la région 103 depuis la phase amorphe vers la phase cristalline. En outre, une autre impulsion présentant une fluence de l'ordre de 185 mJ.cm⁻² est par exemple utilisée pour obtenir une transition du matériau de la région 103 depuis la phase cristalline vers la phase amorphe.

Un inconvénient du commutateur 100 tient au fait que le rayonnement laser émis par la source LS n'est pas absorbé de façon homogène dans la région 103 en matériau à changement de phase le long de la direction de propagation du rayonnement dans le guide d'ondes 105 (le long de l'axe Ox, dans cet exemple). Dans l'exemple du commutateur 100, le rayonnement laser est majoritairement absorbé par une première partie 103N de la région 103 en matériau à changement de phase proche de la source laser LS, l'absorption du rayonnement laser étant plus faible dans une deuxième partie 103F de la région 103 en matériau à changement de phase, opposée à la première partie 103N, plus éloignée de la source laser LS que la partie 103N. L'absorption optique du rayonnement laser par la région 103 en matériau à changement de phase suit plus précisément une exponentielle décroissante depuis la partie 103N de la région 103 jusqu'à la partie 103F.

Ainsi, lors d'une phase d'activation du commutateur 100, la puissance optique absorbée par la deuxième partie 103F de la région 103 peut s'avérer insuffisante pour provoquer un changement de phase du matériau dans la partie 103F. Dans le cas où l'on souhaite faire basculer le commutateur 100 de l'état passant à l'état bloqué, cela peut empêcher la deuxième partie 103F de la région 103 de changer de phase depuis la phase cristalline vers la phase amorphe, autorisant ainsi, de façon indésirable, le passage d'un courant de fuite entre les électrodes de conduction 101A et 101B du commutateur 100.

L'inventeur s'est aperçu que le phénomène provient du fait que le mode transverse magnétique TM du signal laser d'activation du commutateur 100 confiné et guidé par le guide d'ondes 105 est fortement absorbé par le matériau à changement de phase de la région 103, conduisant ainsi à un échauffement de la partie 103N bien supérieur à celui observé dans la partie 103F. Pour pallier ce problème, on aurait pu penser modifier la géométrie du guide d'ondes 105 pour confiner et guider uniquement le mode transverse électrique TE, plus faiblement absorbé par le matériau à changement de phase de la région 103 que le mode transverse magnétique TM. À titre d'exemple, le mode transverse magnétique TM présente des pertes, liées à l'absorption par le matériau à changement de phase de la région 103, de l'ordre de 2 500 dB.cm⁻¹, contre environ 500 dB.cm⁻¹ pour le mode transverse électrique TE. Toutefois, pour des valeurs de puissance laser équivalentes, cela ne permettrait pas d'obtenir un échauffement suffisant de la région 103 pour provoquer un changement de phase. De manière plus générale, tant en mode transverse électrique TE qu'en mode transverse magnétique TM, l'absorption optique suit une loi de type exponentielle décroissante pour cette configuration de guide. Toutefois, il serait préférable que l'absorption suive une loi linéaire pour permettre de modifier l'état du matériau à changement de phase de la région 103.

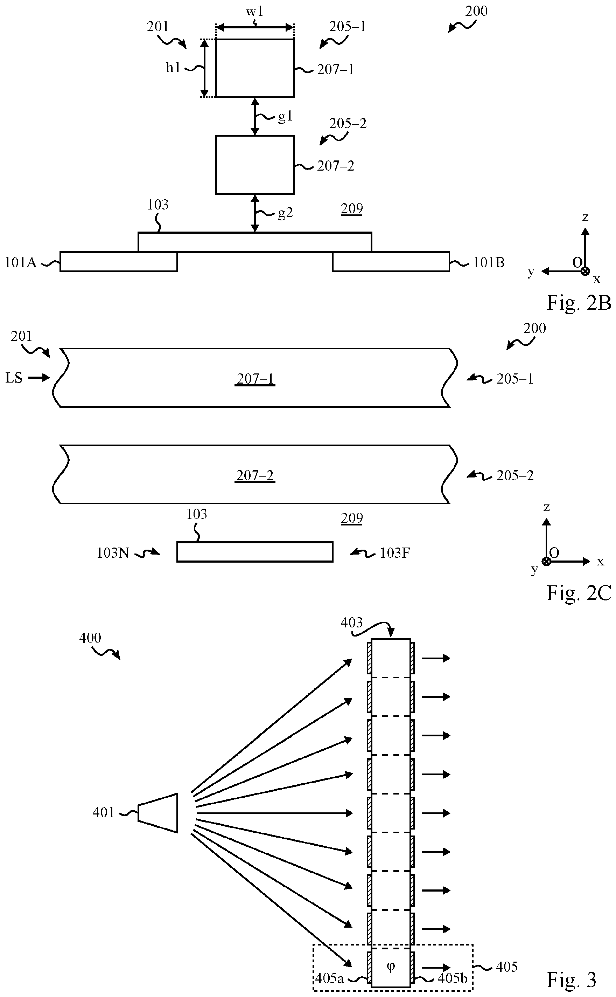

La figure 2A, la figure 2B et la figure 2C sont des vues schématiques et partielles, respectivement de dessus, en coupe selon le plan BB de la figure 2A et en coupe selon le plan CC de la figure 2A, illustrant un exemple de commutateur 200 à base d'un matériau à changement de phase selon un mode de réalisation.

Le commutateur 200 des figures 2A, 2B et 2C comprend des éléments communs avec le commutateur 100 des figures 1A et 1B. Ces éléments communs ne seront pas détaillés à nouveau ci-après. Le commutateur 200 des figures 2A, 2B et 2C diffère du commutateur 100 des figures 1A et 1B en ce que le commutateur 200 comprend un coupleur optique 201. Dans cet exemple, le coupleur optique 201 comporte deux guides d'ondes 205-1 et 205-2 superposés en vis-à-vis de la région 103 en matériau à changement de phase.

Dans l'exemple illustré, le guide d'ondes 205-2 est interposé entre le guide d'ondes 205-1 et la région 103 en matériau à changement de phase. Dans cet exemple, le guide d'ondes 205-1, le plus éloigné de la région 103 en matériau à changement de phase, est destiné à recevoir le signal laser d'activation du commutateur 200 en provenance de la source LS, et le guide d'ondes 205-2, plus proche de la région 103 en matériau à changement de phase que le guide d'ondes 205-1, est destiné à être couplé optiquement, par un champ évanescent, au guide d'ondes 205-1. À titre d'exemple, les guides d'ondes 205-1 et 205-2 forment un coupleur optique 201 de type directionnel.

En référence à l'orientation des figures 2B et 2C, les guides d'ondes 205-1 et 205-2 seront parfois, dans la suite de la description, assortis respectivement des qualificatifs « supérieur » et « inférieur ».

Dans cet exemple, le coupleur optique 201 est conçu de sorte que le signal soit, en entrée du coupleur optique 201, c'est-à-dire au voisinage de la partie 103N de la région 103, confiné et guidé majoritairement dans le guide d'ondes supérieur 205-1 et, en sortie du coupleur optique 201, c'est-à-dire au voisinage de la partie 103F de la région 103, confiné et guidé majoritairement dans le guide d'ondes inférieur 205-2. Les guides d'ondes 205-1 et 205-2 permettent par exemple chacun de confiner et guider le mode transverse magnétique TM du signal laser d'activation du commutateur 200 émis par la source LS. À titre d'exemple, le mode transverse magnétique TM présente des pertes, liées à l'absorption par le matériau à changement de phase de la région 103, de l'ordre de 500 dB.cm⁻¹ pour le guide d'ondes supérieur 205-1, contre environ 2 500 dB.cm⁻¹ pour le guide d'ondes inférieur 205-2. En injectant le signal laser de commande du commutateur 200 dans le guide d'ondes supérieur 205-1, couplé au guide d'ondes inférieur 205-2 à l'aplomb de la région 103 en matériau à changement de phase, la puissance optique se trouve mieux répartie entre la partie 103N de la région 103 en matériau à changement de phase, la plus proche de la source laser LS, et la partie 103F de la région 103, la plus éloignée de la source laser LS. Dans cet exemple, le rayonnement émis par la source laser LS présente une polarisation transverse magnétique TM.

Dans l'exemple représenté, chaque guide d'ondes 205-1, 205-2 présente par exemple une structure identique ou analogue à celle du guide d'ondes 105 précédemment décrite en relation avec les figures 1A et 1B. Dans l'exemple illustré, chaque guide d'ondes 205-1, 205-2 comprend une région centrale 207-1, 207-2, ou âme, entourée d'une région périphérique 209 électriquement isolante. La région centrale 207-1, 207-2 et la région périphérique 209 de chaque guide d'ondes 205-1, 205-2 sont en des matériaux choisis de sorte à obtenir un contraste d'indices optiques permettant de confiner et guider le mode optique d'intérêt émis par la source laser LS. Le matériau de la région centrale 207-1, 207-2 de chaque guide d'ondes 205-1, 205-2 présente par exemple un indice optique supérieur à celui de la région périphérique 209. À titre d'exemple, la région centrale 207-1, 207-2 de chaque guide d'ondes 205-1, 205-2 est en nitrure de silicium et la région périphérique 209 est en dioxyde de silicium.

Dans l'exemple illustré, les régions centrales 207-1 et 207-2 des guides d'ondes 205-1 et 205-2 sont superposées, en regard l'une de l'autre et présentent un même tracé à l'aplomb de la région 103. En revanche, dans cet exemple, les régions 207-1 et 207-2 ne sont pas situées en regard l'une de l'autre et/ou ne présentent pas un même tracé hors de l'aplomb de la région 103 en matériau à changement de phase. Cela permet de faire en sorte que le couplage optique entre les guides d'ondes 205-1 et 205-2 ait majoritairement lieu en vis-à-vis de la région 103. Cela permet en outre de limiter des réflexions optiques dues à un changement d'indice optique brutal, ou abrupt, qui seraient par exemple observées dans un cas où la région 207-2 du guide d'ondes inférieur 205-2 serait interrompue brusquement à l'aplomb de la région 207-1 du guide d'ondes supérieur 205-1.

Le plan BB de la figure 2A est sensiblement orthogonal à une direction de propagation du rayonnement laser dans les guides d'ondes 205-1 et 205-2 en vis-à-vis de la région 103 (orthogonal à l'axe Ox et parallèle au plan Oyz, dans l'exemple illustré). Dans l'exemple représenté, à l'aplomb de la région 103 en matériau à changement de phase, la région périphérique 209 des guides d'ondes 205-1 et 205-2 revêt les faces des régions centrales 207-1 et 207-2 parallèles à la direction de propagation du rayonnement laser (les faces latérales, inférieure et supérieures des régions centrales 207-1 et 207-2 des guides d'ondes 205-1 et 205-2 parallèles à l'axe Ox, dans l'orientation des figures 2A, 2B et 2C). Dans cet exemple, une partie de la région périphérique 209 des guides d'ondes 205-1 et 205-2 s'étend verticalement, le long de l'axe Oz, depuis une face de la région centrale 207-1 située en regard du guide d'ondes inférieur 205-2 (la face inférieure de la région centrale 207-1 du guide d'ondes supérieur 205-1, dans l'orientation de la figure 2B) jusqu'à une face de la région centrale 207-2 du guide d'ondes inférieur 205-2 opposée à la région 103 en matériau à changement de phase (la face supérieure de la région centrale 207-2 du guide d'ondes inférieur 205-2, dans l'orientation de la figure 2B). En outre, une autre partie de la région périphérique 209 des guides d'ondes 205-1 et 205-2 s'étend verticalement, le long de l'axe Oz, depuis une face de la région centrale 207-2 située en regard de la région 103 en matériau à changement de phase (la face inférieure de la région centrale 207-2 du guide d'ondes inférieur 205-2, dans l'orientation de la figure 2B) jusqu'à une face de la région 103 en matériau à changement de phase opposée aux électrodes de conduction 101A et 101B (la face supérieure de la région 103 en matériau à changement de phase, dans l'orientation de la figure 2B).

Dans l'exemple représenté, les régions centrales 207-1 et 207-2 présentent chacune, en vue en coupe selon le plan BB, une section de forme sensiblement rectangulaire. À titre d'exemple, la région centrale 207-1 du guide d'ondes supérieur 205-1 présente une section de forme et de dimensions identiques, aux dispersions de fabrication près, à celles de la région centrale 207-2 du guide d'ondes inférieur 205-2. Plus précisément, dans l'orientation de la figure 2B, la région centrale 207-1, 207-2 de chaque guide d'ondes 205-1, 205-2 présente une même largeur w1, selon l'axe Ox, et une même hauteur h1, selon l'axe Oz. Cet exemple n'est toutefois pas limitatif, la région centrale 207-2 du guide d'ondes inférieur 205-2 pouvant, à titre de variante, présenter une section de forme et de dimensions différentes de celles de la section de la région centrale 207-1 du guide d'ondes supérieur 205-1.

Par ailleurs, la région centrale 207-1 du guide d'ondes supérieur 205-1 est séparée de la région centrale 207-2 du guide d'ondes inférieur 205-2 par une distance g1. Dans cet exemple, la distance g1 équivaut à une épaisseur de la partie de la région périphérique 209 interposée entre la région centrale 207-1 du guide d'ondes 205-1 et la région centrale 207-2 du guide d'ondes 205-2. Par ailleurs, la région centrale 207-2 du guide d'ondes 205-2 est séparée de la région 103 en matériau à changement de phase par une distance g2. Dans cet exemple, la distance g2 équivaut à une épaisseur de la partie de la région périphérique 209 interposée entre la région centrale 207-2 du guide d'ondes 205-2 et la région 103 en matériau à changement de phase.

Le tableau [Table 1] ci-dessous fournit des exemples de valeurs pour la hauteur h1, la largeur w1, et les distances g1 et g2 en fonction d'une largeur L de la région 103 en matériau à changement de phase le long de l'axe Ox, c'est-à-dire perpendiculairement à l'axe Oy de conduction du commutateur 200 et parallèlement à la direction de propagation du signal laser dans le coupleur optique 201. La largeur L de la région 103 en matériau à changement de phase est considérée parallèlement à la direction de propagation du signal laser de commande du commutateur 200 dans le coupleur optique 201 à l'aplomb de la région 103 (parallèlement à l'axe Ox, dans l'exemple illustré).

**[Table 1]**

| L (µm) | g1 (nm) | g2 (nm) | h1 (nm) | w1 (nm) |
|---|---|---|---|---|
| 100 | 600 | 300 | 300 | 1 000 |
| 90 | 700 | 400 | 300 | 400 |
| 55 | 600 | 300 | 300 | 400 |
| 45 | 700 | 300 | 200 | 600 |
| 35 | 350 | 75 | 300 | 450 |
| 30 | 400 | 200 | 300 | 600 |

Le tableau [Table 2] ci-dessous fournit, à titre d'exemple, des valeurs minimales et maximales pour chaque dimension h1, w1 des régions centrales 207-1 et 207-2 des guides d'ondes 205-1 et 205-2 et pour les distances g1 et g2, la largeur L de la région 103 en matériau à changement de phase étant comprise, à titre d'exemple non limitatif, entre 30 et 100 µm.

**[Table 2]**

| Dimension ou distance | Valeur minimale | Valeur maximale |
|---|---|---|
| g1 (nm) | 400 | 700 |
| g2 (nm) | 75 | 400 |
| h1 (nm) | 200 | 300 |
| w1 (nm) | 400 | 1 000 |

Les exemples fournis ci-dessus ne sont toutefois pas limitatifs, et la personne du métier est capable de définir les valeurs des dimensions h1 et w1 des régions centrales 207-1 et 207-2 des guides d'ondes 205-1 et 205-2 et les valeurs des distances g1 et g2 en fonction de la largeur L de la région 103 en matériau à changement de phase. Des outils de simulation numérique peuvent par exemple être utilisés à cette fin. À titre d'exemple, les distances g1 et g2 et la hauteur h1 peuvent être contraintes du fait d'épaisseurs de couches de matériaux déposées lors d'étapes de fabrication du commutateur 200.

Un avantage du commutateur 200 exposé ci-dessus en relation avec les figures 2A, 2B et 2C tient au fait que la présence du coupleur optique permet de faire en sorte que le signal laser de commande du commutateur 200 soit absorbé de façon sensiblement uniforme par le matériau à changement de phase de la région 103. Plus précisément, dans le cas du commutateur 200, seul le mode transverse magnétique TM dans le guide d'ondes supérieur 205-1, faiblement absorbé, est présent à proximité de l'entrée du coupleur optique 201 (à l'aplomb de la partie 103N de la région 103), tandis que seul le mode transverse magnétique TM dans le guide d'ondes inférieur 205-2, fortement absorbé, est présent à proximité de la sortie du coupleur optique 201 (à l'aplomb de la partie 103F de la région 103). Cela permet d'éviter, par rapport au commutateur 100 des figures 1A et 1B, qu'une partie de la région 103 en matériau à changement de phase, par exemple la partie 103F la plus éloignée de la source laser LS, ne change pas de phase lors de la commande du commutateur.

La figure 3 est une vue de côté, schématique et partielle, d'un exemple d'antenne à réseau transmetteur 400 du type auquel s'appliquent, à titre d'exemple, des modes de réalisation décrits.

L'antenne 400 comprend typiquement une ou plusieurs sources primaires 401 (une unique source 401, dans l'exemple représenté) irradiant un réseau transmetteur 403. La source 401 peut présenter une polarisation quelconque, par exemple linéaire ou circulaire. Le réseau 403 comprend une pluralité de cellules élémentaires 405, par exemple disposées en matrice selon des lignes et des colonnes. Chaque cellule 405 comprend typiquement un premier élément d'antenne 405a, situé du côté d'une première face du réseau 403 disposée en regard de la source primaire 401, et un deuxième élément d'antenne 405b, situé du côté d'une deuxième face du réseau 403 opposée à la première face. La deuxième face du réseau 403 est par exemple tournée vers un milieu d'émission de l'antenne 400.

Chaque cellule 405 est apte, en émission, à recevoir un rayonnement électromagnétique sur son premier élément d'antenne 405a et à réémettre ce rayonnement depuis son deuxième élément d'antenne 405b, par exemple en introduisant un déphasage φ connu. En réception, chaque cellule 405 est apte à recevoir un rayonnement électromagnétique sur son deuxième élément d'antenne 405b et à réémettre ce rayonnement depuis son premier élément d'antenne 405a, en direction de la source 401, avec le même déphasage φ. Le rayonnement réémis par le premier élément d'antenne 405a est par exemple focalisé sur la source 401.

Les caractéristiques du faisceau produit par l'antenne 400, notamment sa forme (ou gabarit) et sa direction d'émission maximale (ou direction de pointage), dépendent des valeurs des déphasages respectivement introduits par les différentes cellules 405 du réseau 403.

Les antennes à réseau transmetteur ont pour avantages, entre autres, de présenter une bonne efficacité énergétique et d'être relativement simples, peu onéreuses et peu encombrantes. Cela provient notamment du fait que les réseaux transmetteurs sont réalisables en technologie planaire, généralement sur circuit imprimé.

On s'intéresse ici plus particulièrement aux antennes à réseau transmetteur 403 reconfigurable. Le réseau transmetteur 403 est dit reconfigurable lorsque les cellules élémentaires 405 sont commandables électroniquement de façon individuelle pour modifier leur valeur de déphasage φ, ce qui permet de modifier dynamiquement les caractéristiques du faisceau généré par l'antenne, et notamment de modifier sa direction de pointage sans déplacer mécaniquement l'antenne ou une partie de l'antenne au moyen d'un élément motorisé.

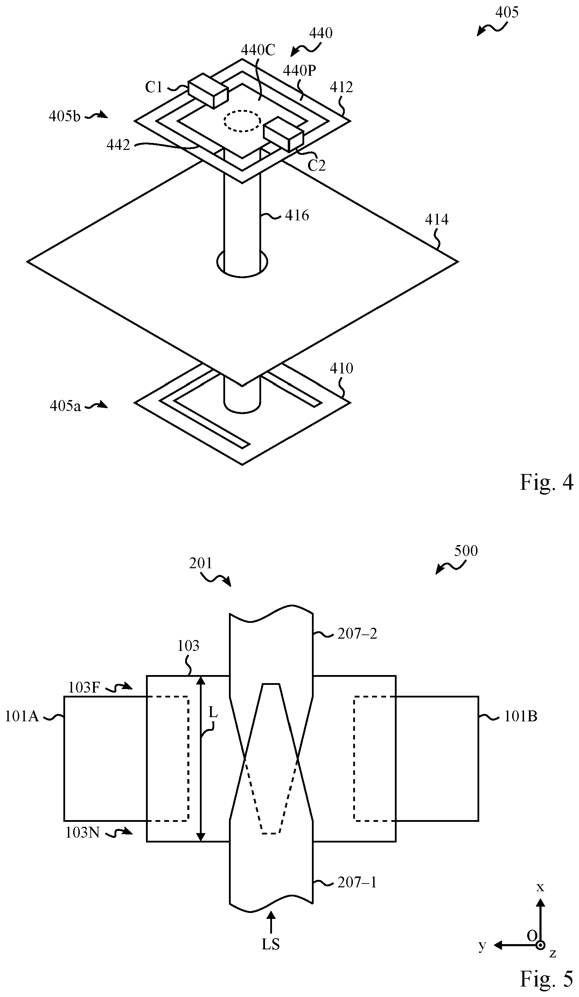

La figure 4 est une vue isométrique, schématique et partielle de l'une des cellules élémentaires 405 du réseau transmetteur 403 de l'antenne 400 de la figure 3 selon un mode de réalisation.

Dans l'exemple représenté, le premier élément d'antenne 405a de la cellule élémentaire 405 comprend une antenne à plaque 410 (« patch antenna », en anglais) adaptée à capter le rayonnement électromagnétique émis par la source 401 et le deuxième élément d'antenne 405b comprend une autre antenne à plaque 412 adaptée à émettre, vers l'extérieur de l'antenne 400, un signal déphasé. Dans l'exemple représenté, la cellule élémentaire 405 comprend en outre un plan de masse 414 intercalé entre les antennes à plaque 410 et 412.

L'antenne 410, le plan de masse 414 et l'antenne 412 sont par exemple respectivement formés dans trois niveaux de métallisation successifs, superposés et séparés les uns des autres par des couches diélectriques, par exemple en quartz. À titre d'exemple, le plan de masse 414 est séparé de chacune des antennes 410 et 412 par une épaisseur de matériau diélectrique de l'ordre de 200 µm.

Dans l'exemple représenté, un via conducteur central 416 connecte l'antenne 410 à l'antenne 412. Plus précisément, dans l'orientation de la figure 4, le via 416 présente une extrémité inférieure en contact avec une face supérieure de l'antenne 410 et une extrémité supérieure en contact avec une face inférieure de l'antenne 412. Le via conducteur central 416 est isolé électriquement du plan de masse 414. Dans l'exemple représenté, le plan de masse 414 comporte un orifice circulaire présentant un diamètre supérieur à celui du via 416, permettant ainsi au via 416 de traverser le plan de masse 414 sans que le via 416 ne soit en contact avec le plan de masse 414. À titre d'exemple, le via conducteur central 416 présente un diamètre égal à environ 80 µm.

Dans l'exemple représenté, l'antenne 412 comporte un plan conducteur 440 à quatre côtés. Le plan conducteur 440 est par exemple plus précisément de forme rectangulaire ou, comme dans l'exemple illustré en figure 4, de forme sensiblement carrée.

Dans l'exemple illustré, le plan conducteur 440 comporte une ouverture 442 séparant une région centrale 440C du plan conducteur 440 d'une région périphérique 440P du plan conducteur 440. Dans cet exemple, l'ouverture 442 présente une forme sensiblement annulaire, par exemple une forme annulaire rectangulaire ou carrée.

Dans l'exemple représenté, le via conducteur central 416 est en contact avec la région centrale 440C du plan conducteur 440. Plus précisément, dans cet exemple, l'extrémité supérieure du via 416 est connectée sensiblement au centre d'une face inférieure de la région 440C. La région centrale 440C du plan conducteur 440, délimitée latéralement par l'ouverture annulaire 442, constitue par exemple une borne d'entrée de l'antenne 412.

L'antenne 412 comporte en outre un premier élément de commutation C1 et un deuxième élément de commutation C2, reliant chacun la région centrale 440C à la région périphérique 440P du plan conducteur 440. Plus précisément, dans l'exemple illustré en figure 4, les premier et deuxième éléments de commutation C1 et C2 contactent la région périphérique 440P dans des zones diamétralement opposées par rapport au via conducteur central 416. Dans cet exemple, les éléments de commutation C1 et C2 et le via conducteur 416 sont situés sur une même droite parallèle à l'un des côtés du plan conducteur 440. Dans cet exemple, le commutateur C1 est situé sensiblement à la verticale de la branche horizontale du U formé par la fente 442.

Les éléments de commutation C1 et C2 sont commandés en opposition, c'est-à-dire de sorte que, si l'un des commutateurs C1, C2 est passant, l'autre commutateur C2, C1 soit bloqué. Cela permet au deuxième élément d'antenne 405b de la cellule élémentaire 405 de commuter entre deux états de phase φ, sensiblement égaux à 0° et à 180° dans cet exemple. Les états de phase 0° et 180° correspondent respectivement au cas où le commutateur C1 est bloqué tandis que le commutateur C2 est passant, et au cas où le commutateur C1 est passant tandis que le commutateur C2 est bloqué.

Chaque élément de commutation C1, C2 de la cellule élémentaire 405 est par exemple réalisé par le commutateur 200 exposé précédemment. Dans ce cas, le fait d'utiliser la source laser LS pour commander les commutateurs C1 et C2 de l'élément d'antenne 405b présente l'avantage de réduire le nombre de lignes électriquement conductrices de commande. Par rapport à des commutateurs en matériau à changement de phase commandés par exemple par chauffage direct, par exemple par circulation d'un courant à travers le matériau à changement de phase, ou par chauffage indirect, par exemple par circulation d'un courant à travers un élément chauffant électriquement isolé du matériau à changement de phase, pour lesquels deux lignes de commande sont utilisées, l'une pour appliquer le potentiel de commande, l'autre pour appliquer le potentiel de référence, une seule ligne de commande optique, par exemple le guide d'ondes supérieur 205-1 du coupleur optique de chaque commutateur C1, C2, est utilisée pour commander la commutation de chaque commutateur C1, C2.

Un autre avantage des commutateurs C1 et C2 tient au fait qu'ils présentent une capacité C_{off} à l'état bloqué inférieure à celle des commutateurs à chauffage indirect usuels, qui comportent typiquement un élément chauffant en un matériau électriquement conducteur, par exemple un métal, électriquement isolé du matériau à changement de phase.

Dans le réseau transmetteur 403, on peut par exemple prévoir d'utiliser une source laser LS différente pour commander chaque commutateur C1, C2 de chaque deuxième élément d'antenne 405b, l'émission des sources laser LS du réseau transmetteur 403 étant commandée par un circuit de commande (non représenté). La source laser LS est alors par exemple de type « intégrée », c'est-à-dire qu'elle fait partie d'une même puce que le ou les commutateurs auxquels elle est associée.

À titre de variante, on peut prévoir d'utiliser une même source laser LS pour commander plusieurs commutateurs C1, C2 des deuxièmes éléments d'antenne 405b du réseau transmetteur 403. Dans ce cas, chaque deuxième élément d'antenne 405b peut par exemple être associé à un commutateur optique de commande des commutateurs C1 et C2 en opposition de phase ou à un multiplexeur de type « 1 vers N », avec N entier strictement supérieur à deux, adapté à commander plusieurs commutateurs C1, C2 de plusieurs deuxièmes éléments d'antenne 405b.

Un avantage des commutateurs C1 et C2 à base de matériau à changement de phase tient au fait qu'ils sont capables de fonctionner à des niveaux de puissance au moins aussi élevés que les commutateurs généralement employés dans des cellules élémentaires d'antennes à réseau transmetteur ou réflecteur reconfigurable, tout en présentant une meilleure linéarité. En outre, les commutateurs C1 et C2 présentent une excellente stabilité dans des plages de fréquences de l'ordre du térahertz.

Par ailleurs, le réseau transmetteur 403 comprenant des cellules 405 intégrant les commutateurs C1 et C2 présente avantageusement une consommation énergétique moindre que les réseaux transmetteurs actuels comportant par exemple des composants tels que des diodes p-i-n ou des varactors.

La figure 5 est une vue de dessus, schématique et partielle, illustrant un exemple de commutateur 500 à base d'un matériau à changement de phase selon un mode de réalisation.

Le commutateur 500 de la figure 5 comprend des éléments communs avec le commutateur 200 des figures 2A, 2B et 2C. Ces éléments communs ne seront pas détaillés à nouveau ci-après. Le commutateur 500 de la figure 5 diffère du commutateur des figures 2A, 2B et 2C en ce que le coupleur optique 201 du commutateur 500 est de type « adiabatique ».

Dans l'exemple représenté, la surface de sortie du guide d'ondes supérieur 205-1 et la surface d'entrée du guide d'ondes 205-2 présentent chacune, en vue de dessus, une forme fuselée. Plus précisément, dans cet exemple, la région centrale 207-1 du guide d'ondes supérieur 205-1 est plus large à l'aplomb de la partie 103N de la région 103 qu'à l'aplomb de la partie 103F, et la région centrale 207-2 du guide d'ondes inférieur 205-2 est plus large à l'aplomb de la partie 103F de la région 103 qu'à l'aplomb de la partie 103N. Cela permet de former, entre le guide d'ondes supérieur 205-1 et le guide d'ondes inférieur 205-2, un couplage de type adiabatique.

Dans l'exemple représenté, les axes de propagation du rayonnement à l'intérieur des guides d'ondes 205-1 et 205-2 sont sensiblement parallèles entre eux, et parallèles à l'axe Ox, les guides d'ondes 205-1 et 205-2 étant par exemple chacun sensiblement rectilignes.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, la géométrie et les dimensions des régions centrales 207-1 et 207-2 des guides d'ondes 205-1 et 205-2, peuvent être adaptées par la personne du métier à partir des indications de la présente description, par exemple en fonction de l'application visée. À titre d'exemple, la région centrale 207-2 du guide d'ondes inférieur 205-2 pourrait débuter à l'aplomb de la partie 103N de la région 103 en matériau à changement de phase et/ou se terminer à l'aplomb de la partie 103F de la région 103.

En outre, bien que l'on ait décrit un exemple de cellule élémentaire 405 comportant deux commutateurs en matériau à changement de phase C1 et C2, les modes de réalisation décrits sont transposables par la personne du métier à un nombre quelconque de commutateurs en matériau à changement de phase. À titre d'exemple, on pourrait prévoir un nombre de commutateurs en matériau à changement de phase supérieur à deux dans un cas où l'on souhaiterait réaliser une cellule élémentaire reconfigurable présentant plus de deux états de phase différents.

Par ailleurs, bien que l'on ait décrit ci-dessus uniquement un exemple d'application à des antennes à réseau transmetteur, le commutateur à base de matériau à changement de phase à commande optique, décrit en relation avec les figures 2A, 2B et 2C, peut avoir d'autres applications. Plus généralement, un tel commutateur peut être utilisé dans toute application susceptible de tirer profit d'une diminution du nombre de pistes de connexion électrique pour commander un commutateur. À titre d'exemple, un tel commutateur peut être intégré à des antennes à réseau réflecteur, des filtres, des circuits déphaseurs, etc. et, plus généralement, à tout type d'application utilisant un commutateur.

En particulier, la transposition des modes de réalisation décrits au cas d'une antenne à réseau réflecteur est à la portée de la personne du métier à partir des indications de la présente description.

Par ailleurs, la personne du métier est capable, à partir des indications de la présente description, de prévoir que chacun des commutateurs à changement de phase C1 et C2 de la cellule élémentaire 405 soit identique ou analogue au commutateur 500 de la figure 5.

Enfin, la mise en œuvre pratique des modes de réalisation et variantes décrits est à la portée de la personne du métier à partir des indications fonctionnelles données ci-dessus. En particulier, les modes de réalisation décrits ne se limitent pas aux exemples particuliers de matériaux et de dimensions mentionnés dans la présente description. Par ailleurs, les modes de réalisation ne se limitent pas à l'exemple de géométrie des antennes à plaque 410 et 412 décrite en relation avec la figure 4, mais s'appliquent plus généralement à tout type de géométrie d'antenne.

## Revendications

1. Commutateur (200 ; 500) à base d'un matériau à changement de phase comprenant :
- une région (103) en ledit matériau à changement de phase reliant des première et deuxième électrodes (101A, 101B) de conduction du commutateur ; et
- un coupleur optique (201) d'un signal laser d'activation du commutateur, situé en vis-à-vis d'une face de la région en ledit matériau à changement de phase, **caractérisé en ce que** le coupleur optique (201) comprend des premier et deuxième guides d'ondes (205-1, 205-2) superposés en vis-à-vis de ladite face, le deuxième guide d'ondes (205-2) étant interposé entre le premier guide d'ondes (205-1) et la région (103) en ledit matériau à changement de phase.

2. Commutateur (200 ; 500) selon la revendication 1, dans lequel les premier et deuxième guides d'ondes (205-1, 205-2) comprennent chacun une région centrale (207-1, 207-2) en un premier matériau entourée par une région périphérique (209) en un deuxième matériau d'indice optique inférieur à celui du premier matériau.

3. Commutateur (200) selon la revendication 2, dans lequel les régions centrales (207-1, 207-2) des premier et deuxième guides d'ondes (205-1, 205-2) sont superposées, en regard l'une de l'autre et présentent un même tracé à l'aplomb de la région (103) en ledit matériau à changement de phase.

4. Commutateur (200) selon la revendication 2 ou 3, dans lequel les régions centrales (207-1, 207-2) des premier et deuxième guides d'ondes (205-1, 205-2) ne présentent pas un même tracé hors de l'aplomb de la région (103) en ledit matériau à changement de phase.

5. Commutateur (200) selon l'une quelconque des revendications 2 à 4, dans lequel la région centrale (207-1) du premier guide d'ondes (205-1) présente une géométrie et des dimensions sensiblement identiques à celles de la région centrale (207-2) du deuxième guide d'ondes (205-2).

6. Commutateur (500) selon la revendication 1 ou 2, dans lequel le coupleur optique (201) est un coupleur adiabatique.

7. Commutateur (500) selon la revendication 6, dans lequel les premier et deuxième guide d'ondes (205-1, 205-2) comportent respectivement des surfaces de sortie et d'entrée présentant chacune, en vue de dessus, une forme fuselée.

8. Commutateur (200 ; 500) selon l'une quelconque des revendications 1 à 7, dans lequel le signal laser est confiné et guidé majoritairement par le premier guide d'ondes (205-1), en entrée du coupleur optique (201), et majoritairement par le deuxième guide d'ondes (205-2), en sortie du coupleur optique.

9. Commutateur (200 ; 500) selon l'une quelconque des revendications 1 à 8, dans lequel les première et deuxième électrodes de conduction (101A, 101B) font partie d'un élément d'antenne (405a) d'une cellule (405) de réseau transmetteur (403) ou de réseau réflecteur.

10. Cellule (405) de réseau transmetteur (403) ou de réseau réflecteur comprenant au moins un commutateur (200 ; 500) selon l'une quelconque des revendications 1 à 9.

11. Réseau transmetteur (403) ou réseau réflecteur comprenant :
- une pluralité de cellules (405) selon la revendication 10 ;
- une ou plusieurs sources laser (LS) ; et
- un circuit de commande de la ou des sources laser.

12. Réseau (403) selon la revendication 11, dans lequel chaque source laser (LS) fait partie d'une même puce que chaque commutateur (200) auquel elle est associée.

13. Antenne (400) comprenant un réseau transmetteur (403) ou un réseau réflecteur selon la revendication 11 ou 12 et au moins une source (401) configurée pour irradier une face du réseau.

## Patentansprüche

1. Schalter (200; 500) auf Basis eines Phasenwechselmaterials, aufweisend:
- einem Bereich (103) aus dem Phasenwechselmaterial, der eine erste und eine zweite Leitungselektrode (101A, 101B) des Schalters koppelt; und
- einem optischen Koppler (201) für ein Lasersignal zum Aktivieren des Schalters, der gegenüber einer Oberfläche des Bereichs aus dem Phasenwechselmaterial angeordnet ist,
**dadurch gekennzeichnet, dass** der optische Koppler (201) einen ersten und einen zweiten Wellenleiter (205-1, 205-2) aufweist, die gegenüber der Oberfläche gestapelt angeordnet sind, wobei der zweite Wellenleiter (205-2) zwischen dem ersten Wellenleiter (205-1) und dem Bereich (103) aus dem Phasenwechselmaterial angeordnet ist.

2. Schalter (200; 500) nach Anspruch 1, wobei die ersten und zweiten Wellenleiter (205-1, 205-2) jeweils einen Mittelbereich (207-1, 207-2) aus einem ersten Material aufweisen, der von einem Umfangsbereich (209) aus einem zweiten Material mit einem niedrigeren Brechungsindex als der des ersten Materials umgeben ist.

3. Schalter (200) nach Anspruch 2, wobei die Mittelbereiche (207-1, 207-2) der ersten und zweiten Wellenleiter (205-1, 205-2) gestapelt angeordnet sind, einander gegenüberliegen und im Lot über dem Bereich (103) aus dem Phasenwechselmaterial ein gleiches Muster aufweisen.

4. Schalter (200) nach Anspruch 2 oder 3, wobei die Mittelbereiche (207-1, 207-2) der ersten und zweiten Wellenleiter (205-1, 205-2) außerhalb des Lots über dem Bereich (103) aus dem Phasenwechselmaterial ein unterschiedliches Muster aufweisen.

5. Schalter (200) nach einem der Ansprüche 2 bis 4, wobei der Mittelbereich (207-1) des ersten Wellenleiters (205-1) eine Geometrie und Abmessungen aufweist, die im Wesentlichen mit denen des Mittelbereichs (207-2) des zweiten Wellenleiters (205-2) identisch sind.

6. Schalter (500) nach Anspruch 1 oder 2, wobei der optische Koppler (201) ein adiabatischer Koppler ist.

7. Schalter (500) nach Anspruch 6, wobei der erste und zweite Wellenleiter (205-1, 205-2) jeweils Ausgangs- und Eingangsflächen aufweisen, die in der Draufsicht jeweils eine sich verjüngende Form haben.

8. Schalter (200; 500) nach einem der Ansprüche 1 bis 7, wobei das Lasersignal am Eingang des optischen Kopplers (201) hauptsächlich durch den ersten Wellenleiter (205-1) und am Ausgang des optischen Kopplers hauptsächlich durch den zweiten Wellenleiter (205-2) begrenzt und geführt wird.

9. Schalter (200; 500) nach einem der Ansprüche 1 bis 8, wobei die ersten und zweiten Leitungselektroden (101A, 101B) Teil eines Antennenelements (405a) einer Zelle (405) eines Transmitarrays (403) oder eines Reflectarrays bilden.

10. Zelle (405) eines Transmitarrays (403) oder eines Reflectarrays, die mindestens einen Schalter (200; 500) gemäß einem der Ansprüche 1 bis 9 aufweist.

11. Transmitarray (403) oder Reflectarray, aufweisend:
- eine Vielzahl von Zellen (405) gemäß Anspruch 10;
- eine oder mehrere Laserquellen (LS); und
- eine Schaltung zum Steuern der Laserquelle(n).

12. Array (403) gemäß Anspruch 11, wobei jede Laserquelle (LS) Teil desselben Chips ist wie jeder Schalter (200), mit dem sie assoziiert ist.

13. Antenne (400) mit einem Transmitarray (403) oder einem Reflectarray gemäß Anspruch 11 oder 12 und mindestens einer Quelle (401), die so konfiguriert ist, dass sie eine Oberfläche des Arrays bestrahlt.

## Claims

1. Switch (200; 500) based on a phase-change material comprising:
- a region (103) made of said phase-change material coupling first and second conduction electrodes (101A, 101B) of the switch ; and
- an optical coupler (201) of a laser signal for activating the switch, located opposite a surface of the region made of said phase-change material,
**characterized in that** the optical coupler (201) comprises first and second waveguides (205-1, 205-2) stacked opposite said surface, the second waveguide (205-2) being interposed between the first waveguide (205-1) and the region (103) made of said phase-change material.

2. Switch (200; 500) according to claim 1, wherein the first and second waveguides (205-1, 205-2) each comprise a central region (207-1, 207-2) made of a first material surrounded by a peripheral region (209) made of a second material having an optical index lower than that of the first material.

3. Switch (200) according to claim 2, wherein the central regions (207-1, 207-2) of the first and second waveguides (205-1, 205-2) are stacked, opposite each other and have a same pattern vertically in line with the region (103) made of said phase-change material.

4. Switch (200) according to claim 2 or 3, wherein the central regions (207-1, 207-2) of the first and second waveguides (205-1, 205-2) do not have a same pattern outside of the vertical alignment with the region (103) made of said phase-change material.

5. Switch (200) according to any of claims 2 to 4, wherein the central region (207-1) of the first waveguide (205-1) has a geometry and dimensions substantially identical to those of the central region (207-2) of the second waveguide (205-2).

6. Switch (500) according to claim 1 or 2, wherein the optical coupler (201) is an adiabatic coupler.

7. Switch (500) according to claim 6, wherein the first and second waveguides (205-1, 205-2) respectively comprise output and input surfaces, each having, in top view, a tapered shape.

8. Switch (200; 500) according to any of claims 1 to 7, wherein the laser signal is confined and guided mainly by the first waveguide (205-1), at the input of the optical coupler (201), and mainly by the second waveguide (205-2), at the output of the optical coupler.

9. Switch (200; 500) according to any of claims 1 to 8, wherein the first and second conduction electrodes (101A, 101B) form part of an antenna element (405a) of a cell (405) of a transmitarray (403) or of a reflectarray.

10. Cell (405) of a transmitarray (403) or of a reflectarray comprising at least one switch (200; 500) according to any of claims 1 to 9.

11. Transmitarray (403) or reflectarray comprising:
- a plurality of cells (405) according to claim 10;
- one or a plurality of laser sources (LS); and
- a circuit for controlling the laser source(s).

12. Array (403) according to claim 11, wherein each laser source (LS) forms part of a same chip as each switch (200) with which it is associated.

13. Antenna (400) comprising a transmitarray (403) or a reflectarray according to claim 11 or 12 and at least one source (401) configured to irradiate a surface of the array.
